# EUROPEAN PATENT APPLICATION

(11) **EP 2 535 941 A2**
(43) Date of publication of application: **19.12.2012**
(21) Application number: 12171522.1
(22) Date of filing: 11.06.2012
(51) Int. Cl.: H01L 31/0216, H01L 31/0224, H01L 31/0296

(54) **Photovoltaic Device with Reflection Enhancing Layer**

(30) Priority: 14.06.2011 US 201113159558
(71) Applicant: General Electric Company, Schenectady, NY 12345 (US)
(72) Inventor: Korevaar, Bastiaan Arie, Niskayuna, NY New York 12309 (US)
(74) Representative: Picker, Madeline Margaret

(57) **Abstract**

A photovoltaic device (10) is provided. The photovoltaic device (10) comprises an absorber layer (20) comprising a chalcogenide material. The photovoltaic device (10) further comprises a back contact (40) and a reflection enhancing layer (30) disposed between the absorber layer (20) and the back contact (40).

## Description

### BACKGROUND

The invention relates generally to photovoltaic devices and, more particularly, to enhancing reflection at the back contact of the photovoltaic devices.

PV (or solar) cells are used for converting solar energy into electrical energy. Typically, in its basic form, a PV cell includes a semiconductor junction made of two or three layers that are disposed on a substrate layer, and two contacts (electrically conductive layers) for passing electrical energy in the form of electrical current to an external circuit. Moreover, additional layers are often employed to enhance the conversion efficiency of the PV device.

There are a variety of candidate material systems for PV cells, each of which has certain advantages and disadvantages. CdTe is a prominent polycrystalline thin-film material, with a nearly ideal bandgap of about 1.45-1.5 electron volts. CdTe also has a very high absorptivity, and films of CdTe can be manufactured using low-cost techniques. Copper Indium Gallium Selenide (CIGS) and Copper Zinc Tin Sulfide (CZTS) are other promising candidate material systems for PV cells because of its high conversion efficiencies and abundance, respectively.

Currently, CdTe photovoltaic devices have either molybdenum or graphite back contacts. With these materials, the reflection at the back contact is relatively poor. At present, the thickness of the absorber layer in CdTe devices is on the order of about 3 microns. As this is significantly thicker than the absorption depth of radiation with λ<800 nm, absorption of the majority of the light incident on the absorber layer is not an issue. However, it would be desirable to use a thinner absorber layer from the perspective of tellurium availability and because of increased interest in using photovoltaic devices with an n-i-p configuration. However, due to the relatively poor reflection at the back contact, some of the light will pass through the absorber without being absorbed, therefore reducing the short circuit current density (J_{sc}).

It would therefore be desirable to provide a photovoltaic device with improved reflection at the back contact.

### BRIEF DESCRIPTION

One aspect of the present invention resides in a photovoltaic device that includes an absorber layer comprising a chalcogenide material. The photovoltaic device further includes a back contact and a reflection enhancing layer disposed between the absorber layer and the back contact.

Another aspect of the present invention resides in a photovoltaic device that includes an absorber layer comprising cadmium and tellurium. The photovoltaic device further includes a back contact and a reflection enhancing layer disposed between the absorber layer and the back contact. The reflection enhancing layer comprises at least one transparent electrically conductive material. The photovoltaic device further includes an intermediate layer. The absorber layer is disposed between the intermediate layer and the reflection enhancing layer. The intermediate layer comprises a material selected from the group consisting of cadmium sulfide (CdS), indium (III) sulfide (In₂S₃), zinc sulfide (ZnS), zinc telluride (ZnTe), zinc selenide (ZnSe), cadmium magnesium telluride (CdMgTe), cadmium selenide (CdSe), oxygenated cadmium sulfide (CdS:O), copper oxide (Cu₂O), amorphous or micro-crystalline silicon and Zn(O,H) and combinations thereof.

Yet another aspect of the present invention resides in a photovoltaic device that includes an absorber layer comprising a chalcogenide material, where the chalcogenide material comprises a doped or undoped composition represented by the formula: Cu_{1-y}In₁₋ₓGaₓSe_{2-z}S_{z} wherein 0≦x≦1; 0≦y≦0.3 and 0≦z≦2. The photovoltaic device further includes a back contact and a reflection enhancing layer disposed between the absorber layer and the back contact. The reflection enhancing layer comprises at least one transparent electrically conductive material.

### DRAWINGS

These and other features, aspects, and advantages of the present invention will become better understood when the following detailed description is read with reference to the accompanying drawings in which like characters represent like parts throughout the drawings, wherein:
FIG. 1 is a schematic cross-sectional diagram of an example photovoltaic cell having a superstrate configuration and including a reflection enhancing layer, in accordance with various embodiments of the present invention; and
FIG. 2. is a schematic cross-sectional diagram of an example photovoltaic cell having a substrate configuration and including a reflection enhancing layer, in accordance with various embodiments of the present invention;
FIG. 3 is a schematic cross-sectional diagram of the example photovoltaic cell shown in FIG. 1 with a buffer layer disposed between the reflection enhancing layer and the absorber layer;
FIG. 4 is a schematic cross-sectional diagram of the example photovoltaic cell shown in FIG. 2 with a buffer layer disposed between the reflection enhancing layer and the absorber layer;
FIG. 5 is a schematic cross-sectional diagram of the example photovoltaic cell shown in FIG. 1 with a p+ layer disposed between the reflection enhancing layer and the absorber layer; and
FIG. 6 is a schematic cross-sectional diagram of the example photovoltaic cell shown in FIG. 2 with a p+ layer disposed between the reflection enhancing layer and the absorber layer.

### DETAILED DESCRIPTION

The terms "first," "second," and the like, herein do not denote any order, quantity, or importance, but rather are used to distinguish one element from another. The terms "a" and "an" herein do not denote a limitation of quantity, but rather denote the presence of at least one of the referenced items. The modifier "about" used in connection with a quantity is inclusive of the stated value, and has the meaning dictated by context, (e.g., includes the degree of error associated with measurement of the particular quantity). In addition, the term "combination" is inclusive of blends, mixtures, alloys, reaction products, and the like.

Moreover, in this specification, the suffix "(s)" is usually intended to include both the singular and the plural of the term that it modifies, thereby including one or more of that term. Reference throughout the specification to "one embodiment," or "another embodiment," "an embodiment," and so forth, means that a particular element (e.g., feature, structure, and/or characteristic) described in connection with the embodiment is included in at least one embodiment described herein, and may or may not be present in other embodiments. Similarly, reference to "a particular configuration" means that a particular element (e.g., feature, structure, and/or characteristic) described in connection with the configuration is included in at least one configuration described herein, and may or may not be present in other configurations. In addition, it is to be understood that the described inventive features may be combined in any suitable manner in the various embodiments and configurations.

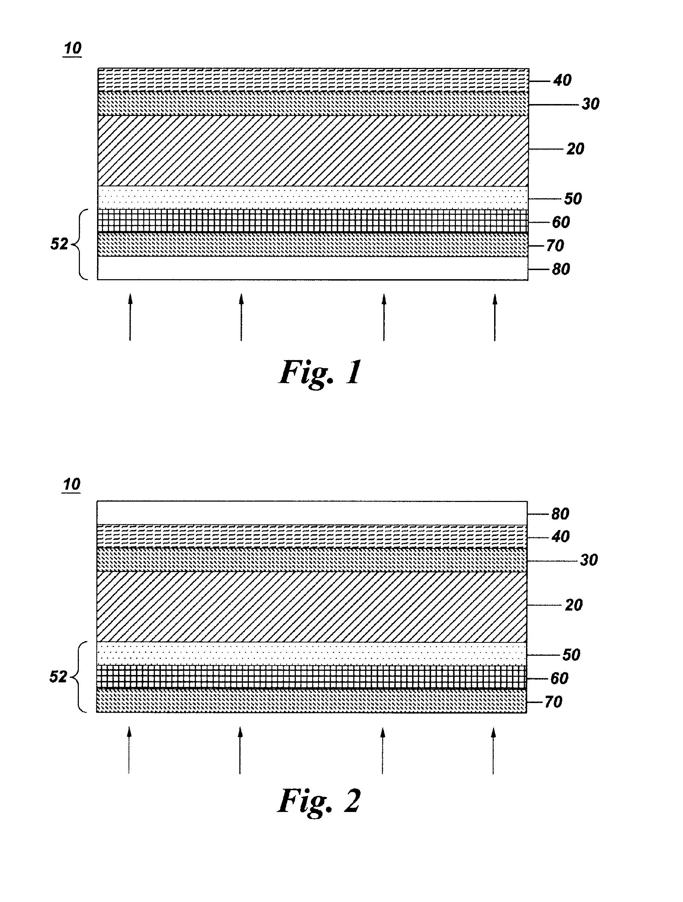

A photovoltaic device 10 embodiment of the invention is described with reference to FIGS. 1-6. As indicated in FIGS. 1 and 2, the photovoltaic device (PV) 10 includes an absorber layer 20 comprising a chalcogenide material. Chalcogenides include at least one chalcogen ion and at least one more elecrtpositive element, and include sulfides, selenides, and tellurides. Non-limiting examples of suitable chalcogenides include cadmium telluride, zinc telluride copper indium gallium selenide (CIGS) and copper zinc tin sulfide (CZTS). Other examples are provided below. It should be noted that the term "layer" encompasses both planar and non-planar layers. A textured layer is one non-limiting example of a non-planar layer. Example chalcogenide materials include a variety of tellurides, as well as CIGS, which are discussed below.

For particular configurations, the chalcogenide material comprises a II-VI compound. Non-limiting example materials of II-VI compounds include zinc telluride (ZnTe), CdTe, magnesium telluride (MgTe), manganese telluride (MnTe), beryllium telluride (BeTe) mercury telluride (HgTe), copper telluride (CuₓTe), and combinations thereof. These materials should also be understood to include the alloys thereof. For example, CdTe can be alloyed with zinc, magnesium, manganese, and/or sulfur to form cadmium zinc telluride, cadmium copper telluride, cadmium manganese telluride, cadmium magnesium telluride and combinations thereof. These materials may be actively doped to be p-type. Suitable dopants vary based on the semiconductor material. For CdTe, suitable p-type dopants include, without limitation, copper, gold, nitrogen, phosphorus, antimony, arsenic, silver, bismuth, and sodium.

Referring to FIGS. 1 and 2, the photovoltaic device 10 further includes a back contact 40 and a reflection enhancing layer 30 disposed between the absorber layer 20 and the back contact 40. The back contact 40 and the reflection enhancing layer 30 are described below. For the arrangements shown in FIGS. 1 and 2, the photovoltaic device 10 further includes an intermediate layer 50. As indicated in FIGS. 1 and 2, the absorber layer 20 is disposed between the intermediate layer 50 and the reflection enhancing layer 30.

Beneficially, the reflection layer 30 enhances the reflection of light at the back contact 40. This enhanced reflection facilitates the use of thinner absorber layers 20. At present, the thickness of the absorber layer in CdTe devices is on the order of about 3 microns. However, for the above-described PV device 10, the thickness of the absorber layer 20 may be less than about 2 microns and, more particularly, less than about 1.5 microns, and still more particularly less than about 1 micron. For other configurations of the PV device 10, a thicker absorber layer 20 may be employed. For example, the absorber layer 20 may be less than about 3 microns. By enhancing the reflection of light at the back contact, the light absorbed by these relatively thin absorber layers 20 increases, such that a relatively high short circuit current density (J_{sc}) can be achieved for these thinner absorber layers 20.

For particular configurations, the chalcogenide material comprises a II-VI compound, and more particularly, comprises cadmium and tellurium, for example CdTe or alloys thereof. CdTe devices are typically formed in a superstrate configuration, as shown for example in FIG. 1. However, more generally, the photovoltaic device 10 may be formed in a substrate (FIG. 2) or superstrate (FIG. 1) configuration. An example CdTe photovoltaic device 10 further includes an intermediate layer 50. As noted above, the absorber layer 20 is disposed between the intermediate layer 50 and the reflection enhancing layer 30. Example materials for the intermediate layer 50 include cadmium sulfide (CdS), indium (III) sulfide (In₂S₃), zinc sulfide (ZnS), zinc telluride (ZnTe), zinc selenide (ZnSe), cadmium magnesium telluride (CdMgTe), cadmium selenide (CdSe), oxygenated cadmium sulfide (CdS:O), copper oxide (Cu₂O), amorphous or micro-crystalline silicon and Zn(O,H) and combinations thereof. More generally, if the absorber layer comprises a p-type semiconductor layer, the intermediate layer 50 comprises a p-type or n-type semiconductor layer. According to a particular embodiment, the intermediate layer 50 comprises CdS and has a thickness in a range of about 50-100 nm. The atomic percent of cadmium in the cadmium sulfide, for certain configurations, is in a range of about 45-55 atomic percent, and more particularly, in a range of about 48-52 atomic percent. For the arrangement shown in FIG. 1, the absorber layer 20 and the intermediate layer 50 form a PN junction, which when exposed to appropriate illumination, generates a photovoltaic current.

For the configurations shown in FIGS. 1 and 2, the photovoltaic device 10 further includes an HRT layer 60 and a transparent conductive oxide (TCO) layer 70. As indicated in FIG. 1, the intermediate layer 50, HRT layer 60, and TCO layer 70 form the window layer 52. For consistency, the same reference numeral 52 is used to identify the intermediate layer 50/HRT layer 60/ TCO layer 70 stack in FIG. 2. Example thickness values for the HRT layer 60 are in a range of about 50 nm to about 100 nm. Beneficially, the HRT layer 70 serves as a buffer layer and can increase the efficiency of the photovoltaic cell 10. Non-limiting examples of suitable materials for HRT layer 20 include tin dioxide (SnO₂), ZTO (zinc stannate), zinc-doped tin oxide (SnO₂:Zn), zinc oxide (ZnO), indium oxide (In₂O₃), and combinations thereof. Non-limiting examples of transparent conductive oxides include indium tin oxide (ITO), fluorine-doped tin oxide (SnO:F) or FTO, indium-doped cadmium-oxide, cadmium stannate (Cd₂SnO₄) or CTO, and doped zinc oxide (ZnO), such as aluminum-doped zinc-oxide (ZnO:Al) or AZO, indium-zinc oxide (IZO), and zinc tin oxide (ZnSnOₓ), and combinations thereof. Depending on the specific TCO employed (and on its sheet resistance), the thickness of the TCO layer 70 may be in the range of about 50-500 nm and, more particularly, 100-200 nm.

For particular configurations, the back contact 40 comprises at least one of aluminum and silver. For particular configurations, the absorber comprises CdTe and the back contact 40 comprises an Ag/Al back metal contact. For these configurations, beneficially the reflection enhancing layer 30 will further serve as a barrier to prevent or reduce diffusion of Aluminum and/or silver into the absorber. For other configurations, the back contact may comprise graphite. For other configurations, the back contact 40 comprises a metal selected from the group consisting of molybdenum, tantalum, tungsten, alloys of molybdenum, tantalum, titanium or tungsten, compounds comprising molybdenum or tungsten (e.g. molybdenumnitride), and combinations thereof. In one non-limiting example, the back contact 40 has a thickness of less than or equal to 100 nm. The back contact 40 may be deposited using a variety of techniques, non-limiting examples of which include evaporation and sputtering. Moreover, the back contact 40 may comprise a stack of multiple metal layers. For example, an aluminum layer with a thickness in a range of 50-1000 nm may be deposited on a molybdenum contact layer. For specific arrangements, a nickel layer with a thickness in a range of about 20-200 nm may be disposed on the aluminum layer. For this arrangement, the back contact 40 comprises the molybdenum/aluminum/nickel stack. In another example, the nickel is replaced with chromium with an example thickness range of about 20-100 nm, such that the back contact 40 comprises the molybdenum/aluminum/chromium stack.

In addition to the examples described above, the chalcogenide material may comprise a doped or undoped composition represented by the formula: Cu_{1-y}In₁₋ₓGaₓSe_{2-z}S_{z} wherein 0≦x≦1; 0≦y≦0.3 nd 0≦z≦2. These materials are generally known as "CIGS," and CIGS PV devices are typically deposited in a substrate geometry, as shown in FIG. 2. It should be noted that a doped composition may encompass the presence of electrically active or inactive dopants that are either intentionally or inadvertently incorporated into the composition.

For other arrangements, the chalcogenide material may comprise a doped or undoped composition represented by the formula: Cu₂ZnSnS₄. These materials are generally known as "CZTS," and CZTS PV devices are typically deposited in a substrate geometry, as shown in FIG. 2. More, generally the CZTS may be optimized, for example by replacing some of the sulfur with selenium. For example, the composition may be represented by the formula Cu₂ZnSnS_{4-q}Se_{q}, where 0≦q≦4. Still more generally, the CZTS may be further optimized and represented by the formula CuₓZn_{y}Sn_{z}S_{4-q}Se_{q}, where 1.8<x<2.2, 0.8<y<1.2, 0.8<z<1.2 and 0≦q≦4. Briefly, copper zinc tin sulfide (CZTS), is a direct bandgap chalcogenide material derived from CIGS, with the indium/gallium of CIGS replaced with the more abundant zinc/tin.

Returning now to a more general discussion of the PV device 10, for particular configurations the reflection enhancing layer 30 comprises at least one transparent electrically conductive material. More particularly, the transparent electrically conductive material has an optical band gap that is larger than the optical band gap of the absorber layer 20. To enhance reflection of the light at the back contact (and hence increase the amount of light absorbed by absorber 20), the thickness t of the reflection enhancing layer 30 has a value equal to n·λ_{c}/4, where n is an integer and ·λ_{c} is the critical wavelength for the absorber layer 20. Namely, the critical wavelength for the absorber is the maximum wavelength that can be absorbed by the absorber and is inversely related to the bandgap E_{g} for the absorber. For particular configurations, the thickness t of the reflection enhancing layer 30 is in the range of about 50-300 nm, and more particularly, in the range of about 100-250 nm.

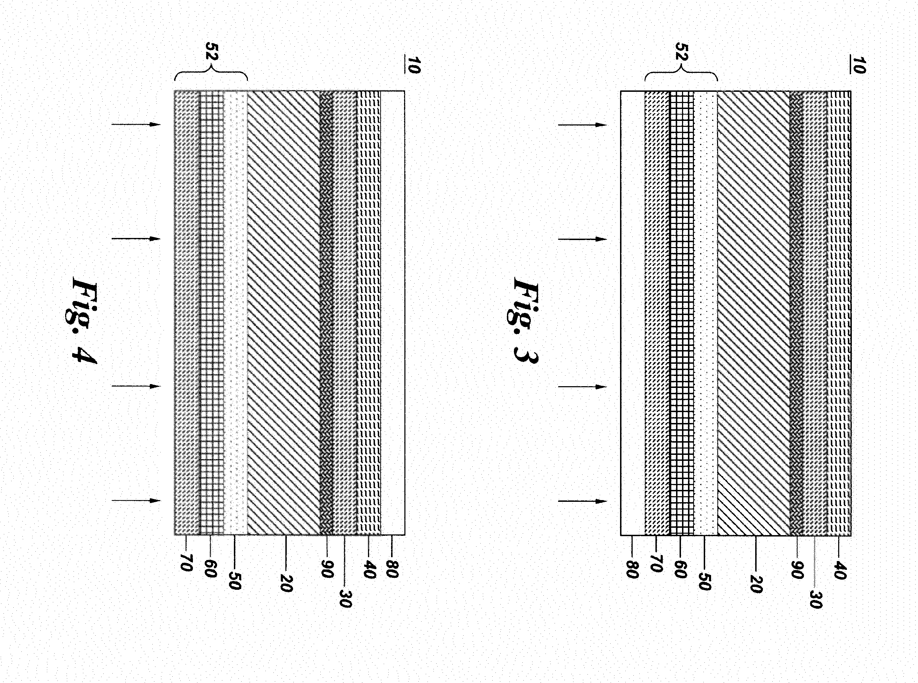

For particular configurations, the transparent electrically conductive material is selected from the group consisting of BaCuSF, BaCuSeF, BaCuTeF, LaCuOS, LaCuOS, (LaSr)CuOS, LaCuOSe, LaCuOSe:Mg, LaCuOTe, LaCuOSe0:6Te0:4, BiCuOSe, (BiCa)CuOSe, PrCuOSe, NdCuOS, CoₓZn_{y}Ni_{z}O₄, where x+y+z=3, and combinations thereof. For the example configurations shown in FIGS. 3 and 4, the photovoltaic device 10 further includes a buffer layer 90 disposed between the absorber layer 20 and the reflection enhancing layer 30. Suitable materials for the buffer layer 90 include, without limitation CdMnTe and MgCdTe. Beneficially, the buffer layer 90 serves to reduce interface recombination.

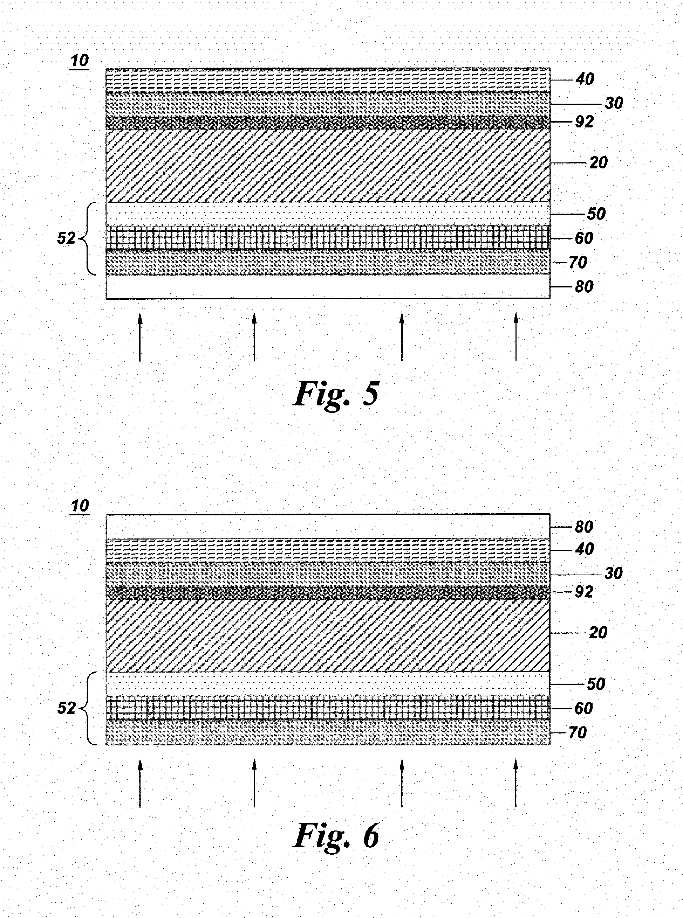

For other configurations, the transparent electrically conductive material comprises an n-type TCO. Non-limiting examples of n-type TCOs include indium tin oxide, fluorine doped tin oxide (FTO), and doped zinc oxide, for example aluminum doped zinc oxide. For the example configurations shown in FIGS. 5 and 6, the photovoltaic device 10 further includes a p+ layer 92 disposed between the absorber layer 20 and the reflection enhancing layer 30. The p+ layer 92 typically has a carrier density in excess of 5 x 10¹⁷ may also include a buffer layer (not shown in FIGS. 5 or 6). Suitable materials for the p+ layer 92 include, without limitation, ZnTe:N:Cu and a-Si:H:B.

For particular configurations, the absorber layer 20 and the reflection enhancing layer 30 have the same dominant carrier type. For example, for this configuration, for a CdTe absorber layer 20, the reflection enhancing layer 30 would also be p-type. For other configurations, the reflection enhancing layer 30 could be n-type, if the carrier density in a p+ type absorber layer is sufficiently large, for example exceeds 1 x 10¹⁸ cm⁻³. If the reflection enhancing layer 30 is in direct contact with the absorber layer 20, then the valence bands must be aligned. For other arrangements, a p-type region may be disposed between the reflection enhancing layer 30 and the absorber layer 20.

For particular device configurations, the photovoltaic device 10 comprises an absorber layer 20 comprising cadmium and tellurium, a back contact 40, and a reflection enhancing layer 30 disposed between the absorber layer 20 and the back contact 40, as indicated for example in FIG. 1. For these configurations, the reflection enhancing layer 30 comprises at least one transparent electrically conductive material. The photovoltaic device 10 further comprises an intermediate layer 50, which comprises a material selected from the group consisting of cadmium sulfide (CdS), indium (III) sulfide (In₂S₃), zinc sulfide (ZnS), zinc telluride (ZnTe), zinc selenide (ZnSe), cadmium magnesium telluride (CdMgTe), cadmium selenide (CdSe), oxygenated cadmium sulfide (CdS:O), copper oxide (Cu₂O), amorphous or micro-crystalline silicon and Zn(O,H) and combinations thereof. As indicated, for example, in FIG. 1, the absorber layer 20 is disposed between the intermediate layer 50 and the reflection enhancing layer 30. According to a particular embodiment, the intermediate layer 50 comprises CdS and has a thickness in a range of about 50-100 nm. As noted above, for the arrangement shown in FIG. 1, the absorber layer 20 and the intermediate layer 50 form a PN junction, which when exposed to appropriate illumination, generates a photovoltaic current.

For more particular device configurations, the thickness of the absorber layer 20 is less than about 2 microns and, more particularly, less than about 1.5 microns, and still more particularly less than about 1 micron. Beneficially, the enhanced reflection provided by reflection enhancing layer 30 facilitates the use of thinner absorber layers 20, while still achieving a relatively high short circuit current density (J_{sc}) for the thinner absorber layers 20. For these specific arrangements, the transparent electrically conductive material used to form the reflection enhancing layer 30 has an optical band gap that is larger than the optical band gap of the absorber layer 20. As noted above, to enhance reflection of the light at the back contact (and hence increase the amount of light absorbed by absorber 20), the thickness t of the reflection enhancing layer 30 has a value equal to λ_{c}/(4*n), wherein n is a function of the refractive indices of the reflection enhancing layer (30) and the surrounding layers, and λ_{c} is the critical wavelength for the absorber layer 20. Accordingly, for these specific arrangements, the thickness t of the reflection enhancing layer 30 is in the range of about 50-300 nm.

For particular arrangements, the transparent electrically conductive material used to form the reflection enhancing layer 30 is selected from the group consisting of BaCuSF, BaCuSeF, BaCuTeF, LaCuOS, LaCuOS, (LaSr)CuOS, LaCuOSe, LaCuOSe:Mg, LaCuOTe, LaCuOSe0:6Te0:4, BiCuOSe, (BiCa)CuOSe, PrCuOSe, NdCuOS, CoₓZn_{y}Ni_{z}O₄, where x+y+z=3, and combinations thereof. For the example configuration shown in FIG. 3, the photovoltaic device 10 further comprises a buffer layer 90 disposed between the absorber layer 20 and the reflection enhancing layer 30. As discussed above, the buffer layer 90 serves to reduce interface recombination and could be CdMnTe or MgCdTe, for example.

For other arrangements, the transparent electrically conductive material used to form the reflection enhancing layer 30 comprises an n-type TCO, non-limiting examples of which are provided above. For the example configuration shown in FIG. 5, the photovoltaic device 10 further comprises a p+ layer 92 disposed between the absorber layer 20 and the reflection enhancing layer 30. The p+ layer 92 is described above with reference to FIG. 5.

For other device configurations, the photovoltaic device 10 comprises an absorber layer 20 comprising a chalcogenide material, where the chalcogenide material comprises a doped or undoped composition represented by the formula: Cu_{1-y}In₁₋ₓGaₓSe_{2-z}S_{z} wherein 0≦x≦1; 0≦y≦0.3 and 0≦z≦2. It should be noted that a doped composition may encompass the presence of electrically active or inactive dopants that are either intentionally or inadvertently incorporated into the composition. As indicated, for example, in FIG. 2, the photovoltaic device 10 further includes a back contact 40 and a reflection enhancing layer 30 disposed between the absorber layer 20 and the back contact 40, where the reflection enhancing layer 30 comprises at least one transparent electrically conductive material. Although CIGS PV devices are typically deposited in a substrate geometry, as shown in FIG. 2, the photovoltaic device 10 may also be formed in a superstrate configuration, as shown in FIG. 1. For particular arrangements, the transparent electrically conductive material used to form the reflection enhancing layer 30 has an optical band gap that is larger than the optical band gap of the absorber layer 20, and, wherein the thickness t of the reflection enhancing layer 30 has a value equal to n·λ_{c}/4, where n is an integer and ·λ_{c} is the critical wavelength for the absorber layer 20.

Beneficially, the incorporation of the reflection enhancing layer into the photovoltaic devices increases the optical path length in the absorber and thereby facilitates the use of relatively thin absorber layers, for example CdTe absorber layers that are less than about 2 microns and, more particularly, less than about 1.5 microns in thickness. In this manner, PV devices with relatively thin absorber layers can be fabricated without deleteriously impacting the short circuit current density (J_{sc}).

Although only certain features of the invention have been illustrated and described herein, many modifications and changes will occur to those skilled in the art. It is, therefore, to be understood that the appended claims are intended to cover all such modifications and changes as fall within the scope of the invention as defined therein.

## Claims

1. A photovoltaic device (10) comprising:
an absorber layer (20) comprising a chalcogenide material;
a back contact (40); and
a reflection enhancing layer (30) disposed between the absorber layer (20) and the back contact (40).

2. The photovoltaic device (10) of claim 1, further comprising an intermediate layer (50), wherein the absorber layer (20) is disposed between the intermediate layer (50) and the reflection enhancing layer (30).

3. The photovoltaic device (10) of Claim 1 or Claim 2, wherein the absorber layer (20) comprises cadmium and tellurium.

4. The photovoltaic device (10) of Claim 3, further comprising an intermediate layer (50), wherein the absorber layer (20) is disposed between the intermediate layer (50) and the reflection enhancing layer (30).

5. The photovoltaic device (10) of Claim 3 or Claim 4, wherein the intermediate layer (50) comprises a material selected from the group consisting of cadmium sulfide (CdS), indium (III) sulfide (In₂S₃), zinc sulfide (ZnS), zinc telluride (ZnTe), zinc selenide (ZnSe), cadmium magnesium telluride (CdMgTe), cadmium selenide (CdSe), oxygenated cadmium sulfide (CdS:O), copper oxide (Cu₂O), amorphous or micro-crystalline silicon and Zn(O,H) and combinations thereof.

6. The photovoltaic device (10) of Claim 3, 4 or 5, wherein a thickness of the absorber layer (20) is less than about 2 microns.

7. The photovoltaic device (10) of any one of Claims 1 to 6, wherein the reflection enhancing layer (30) comprises at least one transparent electrically conductive material, and wherein the transparent electrically conductive material preferably has an optical band gap that is larger than an optical band gap of the absorber layer (20).

8. The photovoltaic device (10) of Claim 7, wherein a thickness t of the reflection enhancing layer (30) has a value equal to λ_{c}/(4*n), wherein n is a function of the refractive indices of the reflection enhancing layer and of at least one surrounding layer, and λ_{c} is the critical wavelength for the absorber layer (20).

9. The photovoltaic device (10) of Claim 7 or Claim 8, wherein at least one of:
a thickness t of the reflection enhancing layer (30) is in a range of about 50-300 nm;
the transparent electrically conductive material is selected from the group consisting of BaCuSF, BaCuSeF, BaCuTeF, LaCuOS, LaCuOS, (LaSr)CuOS, LaCuOSe, LaCuOSe:Mg, LaCuOTe, LaCuOSe0:6Te0:4, BiCuOSe, (BiCa)CuOSe, PrCuOSe, NdCuOS, Co_{c}Zn_{y}Ni₂O₄, where x+y+z=3, and combinations thereof;
a buffer layer is disposed between the absorber layer (20) and the reflection enhancing layer (30).

10. The photovoltaic device (10) of Claim 7, 8 or 9, wherein the transparent electrically conductive material comprises an n-type TCO, and preferably further comprising a p+ layer disposed between the absorber layer (20) and the reflection enhancing layer (30).

11. The photovoltaic device (10) of any one of Claims 1 to 9, wherein the chalcogenide material comprises a doped or undoped composition represented by the formula:
CuₓZnySn_{z}S_{4-q}Se_{q}, wherein 1.8<x<2.2, 0.8<y<1.2, 0.8<z<1.2 and 0≦q≦4, or
the formula: Cu_{1-y}In₁₋ₓGaₓSe_{2-z}s_{z} wherein 0≦x≦1; 0≦y≦0.3 and 0≦z≦2.

12. A photovoltaic device (10) comprising:
an absorber layer (20) comprising cadmium and tellurium;
a back contact (40);
a reflection enhancing layer (30) disposed between the absorber layer (20) and the back contact (40), wherein the reflection enhancing layer (30) comprises at least one transparent electrically conductive material; and
an intermediate layer (50), wherein the absorber layer (20) is disposed between the intermediate layer (50) and the reflection enhancing layer (30), and wherein the intermediate layer (50) comprises a material selected from the group consisting of cadmium sulfide (CdS), indium (III) sulfide (In₂S₃), zinc sulfide (ZnS), zinc telluride (ZnTe), zinc selenide (ZnSe), cadmium magnesium telluride (CdMgTe), cadmium selenide (CdSe), oxygenated cadmium sulfide (CdS:O), copper oxide (Cu₂O), amorphous or micro-crystalline silicon and Zn(O,H) and combinations thereof.

13. The photovoltaic device (10) of Claim 12, wherein at least one of:
a thickness of the absorber layer (20) is less than about 2 microns;
the transparent electrically conductive material has an optical band gap that is larger than an optical band gap of the absorber layer; and
wherein a thickness t of the reflection enhancing layer is in a range of about 50-300 nm.

14. The photovoltaic device (10) of Claim 12 or Claim 13, wherein the transparent electrically conductive material is selected from the group consisting of BaCuSF, BaCuSeF, BaCuTeF, LaCuOS, LaCuOS, (LaSr)CuOS, LaCuOSe, LaCuOSe:Mg, LaCuOTe, LaCuOSe0:6Te0:4, BiCuOSe, (BiCa)CuOSe, PrCuOSe, NdCuOS, CoₓZn_{y}Ni_{z}O₄, where x+y+z=3, and combinations thereof, the photovoltaic device (10) preferably further comprising a buffer layer (90) disposed between the absorber layer (20) and the reflection enhancing layer (30).

15. A photovoltaic device (10) comprising:
an absorber layer (20) comprising a chalcogenide material, wherein the chalcogenide material comprises a doped or undoped composition represented by the formula: Cu_{1-y}In₁₋ₓGaₓSe_{2-z}S_{z} wherein 0≦x≦1; 0≦y≦0.3 nd 0≦z≦2;
a back contact (40); and
a reflection enhancing layer (30) disposed between the absorber layer (20) and the back contact (40), wherein the reflection enhancing layer (30) comprises at least one transparent electrically conductive material, and wherein the transparent electrically conductive material has an optical band gap that is larger than an optical band gap of the absorber layer (20).

16. The photovoltaic device (10) of Claim 15, wherein the transparent electrically conductive material has an optical band gap that is larger than an optical band gap of the absorber layer (20); and preferably a thickness t of the reflection enhancing layer has a value equal λ_{c}/(4*n), wherein n is a function of the refractive indices of the reflection enhancing layer (30) and of at least one surrounding layer, and λ_{c} is the critical wavelength for the absorber layer (20).
